# EUROPEAN PATENT APPLICATION

(11) **EP 2 790 197 A2**
(43) Date of publication of application: **15.10.2014**
(21) Application number: 14162513.7
(22) Date of filing: 28.03.2014
(51) Int. Cl.: H01G 9/20

(54) **Electrolyte for dye sensitized solar cell and dye sensitized solar cell using the same**

(30) Priority: 09.04.2013 KR 20130038840
(71) Applicant: Samsung SDI Co., Ltd., Yongin-si, Gyeonggi-do (KR)
(72) Inventor: Eom, Sang-Hyun, Gyeonggi-do (KR); Cha, Si-Young, Gyeonggi-do (KR)
(74) Representative: Mounteney, Simon James

(57) **Abstract**

An electrolyte for a dye sensitized solar cell includes lithium perchlorate and 1-methylbenzimidazole, and when the electrolyte is applied to a dye sensitized solar cell, deterioration of lifespan characteristics due to rapid Jsc deterioration is suppressed.

## Description

### BACKGROUND

### 1. Field

Aspects of one or more embodiments of the present invention relate to an electrolyte for a dye sensitized solar cell and a dye sensitized solar cell using the same.

### 2. Description of the Related Art

To address recently arising energy problems, a comprehensive research into how to use nature energy, such as wind power, atomic power, or solar power, which can be used instead of the petroleum source that may be depleted within decades, is being performed. From among these, solar cells using solar energy are getting attention after their development in 1983 due to limitless source and environmental friendliness. The first developed form of a solar cell was a silicon solar cell, of which manufacturing costs are very high, and thus, it is difficult to commercialize the solar cell and improve the efficiency of a battery. However, such problems are overcome by developing dye sensitized solar cells, of which manufacturing costs are substantially low.

The solar cell published by Gratzel et al. in Switzerland in 1991 is a representative example of dye sensitized solar cells which are known up to now. The solar cell of Gratzel et al. includes a semiconductor electrode formed of metal oxide coated with photosensitive dye molecules that absorb visible light to generate an electron-hole pair, an opposite electrode including a platinum catalyst, and an electrolyte that fills a space between the semiconductor electrode and the opposite electrode and includes a redox ion pair.

Among the constituting elements, the electrolyte transports electron between the semiconductor electrode and the opposite electrode, and is a critical element that determines photoelectric efficiency and durability of the solar cell. A comparable dye sensitized solar cell often uses a liquid electrolyte using a volatile organic solvent. Although the liquid electrolyte has high photoelectric conversion efficiency due to its high ion conductivity, the liquid electrolyte has low durability due to its volatile properties and leakage phenomenon.

Recently, research into improvement on a comparable liquid electrolyte by using ionic liquid is being carried out. Also, the addition of alkali metal halides, such as Lil, Csl, Mgl₂, or the like to an electrolyte may contribute to the improvement in rapid short current density (Jsc). Such alkali metal halide additives existing in an electrolyte may contribute to an initial efficiency. However, in terms of a long-term lifespan, rapid short current density (Jsc) drop may occur. Accordingly, it is difficult to apply such an electrolyte including an alkali metal halide to actual products.

### SUMMARY

Aspects of embodiments of the present invention are directed toward an electrolyte for a dye sensitized solar cell as described in claims 1 to 10 that reduces Jsc deterioration to improve lifespan characteristics.

Aspects of embodiments of the present invention are also directed toward a dye sensitized solar cell including the electrolyte as described in claim 11.

According to an embodiment of the present invention, an electrolyte for a dye sensitized solar cell includes lithium perchlorate and 1-methylbenzimidazole.

According to an embodiment of the present invention, a concentration of the lithium perchlorate is more than 0 and less than 0.5 M.

According to an embodiment of the present invention, a concentration of the 1-methylbenzimidazole is more than 0 and less than 0.5 M.

The electrolyte may be a liquid electrolyte comprising an organic solvent.

According to an embodiment of the present invention, the electrolyte includes as a redox derivative at least one salt selected from the group consisting of an imidazolium salt, a pyridinium salt, a quaternary ammonium salt, a pyrrolidinium salt, a thiazolinium salt, a pyridazinium salt, an isothiazolidinium salt, and an isooxyzolidinium salt.

According to an embodiment of the present invention, the electrolyte further includes guanidine thiocyanate.

According to another embodiment of the present invention, a dye sensitized solar cell includes: a first electrode; a light absorption layer on a side of the first electrode; a second electrode facing the side of the first electrode with the light absorption layer thereon; and the electrolyte between the first electrode and the second electrode.

### BRIEF DESCRIPTION OF THE DRAWINGS

The above and other features and enhancements of the present invention will become more apparent by describing in more detail some example embodiments thereof with reference to the attached drawings in which:
FIG. 1 is a schematic view illustrating an operational principle of a dye sensitized solar cell;
FIG. 2 is a schematic view of a dye sensitized solar cell according to an embodiment of the present invention;
FIG. 3 shows short current density (Jsc) measurement results according to time of the dye sensitized solar cells of Comparative Examples 1 and 2 and Example 1;
FIG. 4 shows short current density (Jsc) measurement results according to time of the dye sensitized solar cells of Comparative Examples 2 and 3 and Example 3;
FIG. 5 shows short current density (Jsc)-voltage (V) measurement results of the dye sensitized solar cells of Comparative Examples 2 and 3 and Example 3.
FIG. 6 shows short current density (Jsc)-voltage (V) measurement results of the dye sensitized solar cells of Examples 2 and 3;
FIG. 7 is a graph showing short current density (Jsc) of the dye sensitized solar cells of Comparative Example 2 and Examples 2 through 4;
FIG. 8 is a graph showing power conversion efficiency (PCE) of the dye sensitized solar cells of Comparative Example 2 and Examples 2 through 4;
FIG. 9 shows PCE measurement results according to time of the dye sensitized solar cells of Comparative Examples 2, 4, and 5 and Example 3;
FIG. 10 shows interface resistance analysis results obtained by irradiating 1 sun and AM 1.5 of light to the dye sensitized solar cells of Comparative Example 1 and Example 3 for 336 hours;
FIG. 11 shows interface resistance analysis results obtained by leaving the dye sensitized solar cells of Comparative Example 1 and Example 3 for 336 hours in a dark condition in which light is not irradiated; and
FIG. 12 shows high-temperature stability analysis results of the electrolytes of Comparative Preparation Example 2 and Preparation Example 3.

### DETAILED DESCRIPTION

Expressions such as "at least one of," when preceding a list of elements, modify the entire list of elements and do not modify the individual elements of the list.

Hereinafter, embodiments of the present invention are described in more detail. Examples and constituents illustrated in the drawings of the present specification are only embodiments of the present invention and do not represent all the technical features of the present invention. Accordingly, it may be considered that, at the time of filing, there are equivalent or different forms of the present embodiments and the equivalent or different forms should not be construed as being limited to the descriptions set forth herein.

All concentrations given below are recited relative to the total amount of electrolyte, unless explicitly recited otherwise.

An electrolyte for a dye sensitized solar cell, according to an embodiment of the present invention, includes lithium perchlorate and 1-methylbenzimidazole.

Lithium perchlorate and 1-methylbenzimidazole are used instead of an alkali metal halide, such as Lil, Csl, or Mgl₂, which is used as a comparable additive to a liquid electrolyte. Accordingly, although an electrolyte that includes a comparable alkali metal halide as an additive may undergo a rapid Jsc drop, an electrolyte including lithium perchlorate and 1-methylbenzimidazole may substantially less likely to undergo the Jsc drop.

In general, a small ion, such as Li⁺ ion, existing in an electrolyte has high affinity to the surface of a TiO₂ semiconductor layer, and thus, a conduction band edge (at the surface) of a semiconductor layer may be shifted toward a lower energy. On the other hand, 1-methylbenzimidazole added to the electrolyte may combine with a Li⁺ ion to form a bulky cation, thereby causing a decrease in the affinity of Li⁺ ion to the surface of the semiconductor layer and also, effectively protecting a ligand (for example, a SCN- ligand) of dye molecules.

Also, in the case of an alkali metal halide, such as Lil, Csl, or Mgl₂, which is used as a comparable electrolyte additive, a provided iodine ion (I⁻ provided by the alkali metal halide) may attack a ligand (for example, a SCN- ligand) of dye molecules, thereby changing the iodine concentration ratio (I⁻/I₃⁻) in the electrolyte. The change in the iodine concentration ratio (I⁻/I₃⁻) may adversely affect a redox potential and reduces a voltage. On the other hand, in the case of lithium perchlorate added to the electrolyte, since a perchlorate ion (ClO₄⁻) has more resonance structures and higher stability than the iodine ion (I⁻), it is less likely that the perchlorate ion (ClO₄⁻) attacks a ligand of dye molecules, such as SCN⁻, and thus, the iodine concentration ratio (I⁻/I₃⁻) in the electrolyte may be more stably maintained, which may lead to a higher voltage.

According to an embodiment of the present invention, a concentration of lithium perchlorate may preferably be more than 0 and less than 0.5 M. In one embodiment, when the concentration of lithium perchlorate is within this concentration range, maximum efficiency is improved and stable lifespan characteristics is obtained. The concentration of lithium perchlorate may preferably be in a range of about 0.1 to about 0.3 M, in one embodiment, about 0.1 to about 0.25 M, and in another embodiment, about 0.1 to about 0.2 M, for example, 0. 05 M to 0.25 M and 0. 08 M to 0.20M.

According to an embodiment of the present invention, a concentration of 1-methylbenzimidazole may preferably be more than 0 and less than 0.5 M. In one embodiment, when the concentration of 1-methylbenzimidazole is within this concentration range, improved maximum efficiency and stable lifespan characteristics are obtained. The concentration of 1-methylbenzimidazole may preferably be in a range of about 0.1 to about 0.3 M, in one embodiment, about 0.1 to about 0.25 M, and in another embodiment, about 0.1 to about 0.2 M, for example, 0. 05 M to 0.25 M and 0. 08 M to 0.20M.

According to an embodiment of the present invention, the suppression on Jsc deterioration due to interactions between lithium perchlorate and 1-methylbenzimidazole is enhanced or maximized by adding lithium perchlorate and 1-methylbenzimidazole in the same amount to the electrolyte.

The electrolyte for a dye sensitized solar cell may preferably be a liquid electrolyte including an organic solvent. The organic solvent may preferably be a non-volatile or low-volatile organic solvent, and may preferably have a boiling point of, in one embodiment, about 120°C or higher, and in another embodiment, about 150°C or higher.

The organic solvent may preferably be, for example, propandiol-1,2-carbonate (PDC), ethylene carbonate (EC), diethylene glycol, propylene carbonate (PC), hexamethylphosphoramide (HMPA), ethyl acetate, nitrobenzene, formamide, γ-butyrolactone (GBL), benzyl alcohol, N-methyl-2-pyrrolidone (NMP), acetophenone, ethylene glycol, trifluorophosphate, benzonitrile (BN), valeronitrile (VN), acetonitrile (AN), 3-methoxy propionitrile (MPN), dimethylsulfoxide (DMSO), dimethyl sulfate, aniline, N-methylformamide (NMF), phenol, 1,2-dichlorobenzene, tri-n-butyl phosphate, o-dichlorobenzene, cellenium oxychloride, ethylene sulfate, benzenethiol, dimethyl acetamide, N,N-dimethylethaneamide (DMEA), 3-methoxypropionnitrile (MPN), diglyme, cyclohexanol, bromobenzene, cyclohexanone, anisole, diethylformamide (DEF), dimethylformamide (DMF), 1-hexanethiol, hydrogen peroxide, bromoform, ethyl chloroacetate, 1-dodecanthiol, di-n-butylether, dibutyl ether, acetic anhydride, m-xylene, p-xylene, chlorobenzene, morpholine, diisopropyl etheramine, diethyl carbonate (DEC), 1-pentandiol, n-butyl acetate1-hexadecanthiol, or the like, and may not be limited thereto. For example, the organic solvent may be any one of various materials that are used as a solvent for an electrolyte for a solar cell in the art. Such organic solvents may be used alone or in combination of two or more of these.

The electrolyte for a dye sensitized solar cell may preferably include, as a redox pair, I⁻ and I₃⁻, and the iodine ion (I⁻) may be provided from an iodide salt. The iodide salt may not include an alkali metal, and the iodide salt may be an ionic liquid, such as an imidazolium salt, a pyridinium salt, a quaternary ammonium salt, a pyrrolidinium salt, a thiazolinium salt, a pyridazinium salt, an isothiazolidinium salt, or an isooxyzolidinium salt. The ionic liquid may be in a molten state in a wide temperature range, including room temperature, and may preferably have high electrochemical stability, high ion conductivity, low melting point, and thermal stability.

According to an embodiment of the present invention, the iodide salt is an imidazolium salt. The imidazolium salt may preferably be, for example, at least one salt selected from the group consisting of 1-methyl-3-propylimidazolium iodide, 1,3-dimethylimidazolium iodide, 1-ethyl-3-methylimidazolium iodide, 1-butyl-3-methylimidazolium iodide, 1-methyl-3-pentylimidazolium iodide, 1-hexyl-3-methylimidazolium iodide, 1-heptyl-3-methylimidazolium iodide, 1-methyl-3-octylimidazolium iodide, 1,3-diethylimidazolium iodide, 1-ethyl-3-propylimidazolium iodide, 1-ethyl-3-butylimidazolium iodide, 1,3-dipropylimidazolium iodide, and 1-butyl-3-propylimidazolium iodide.

A concentration of the iodide salt may preferably be in a range of about 0.1 to about 2 M. In one embodiment, when the concentration of the iodide salt is within this concentration range, the delivery of electrons through a redox reaction, that is, the delivery of electrons to a ground state of dye is easily performed. For example, the concentration of the iodide salt may preferably be in a range of about 0.5 to about 1.5 M, preferably about 0.75 M to about 1.3 M.

Also, the electrolyte may preferably further include, in addition to the iodide salt, iodine (I₂) to form a redox pair. When an amount of iodine is too small, regeneration due to the delivery of electrons to dye molecules by virtue of a redox reaction may not be efficiently performed, and when an amount of iodine is too great, the amount of the iodide salt is relatively too small, and thus ions may not efficiently conduct and efficiency of a solar cell may decrease. The concentration of iodine may preferably be, for example, in a range of about 0.01 to about 0.5 M, preferably about 0.05 M to 0.20 M.

According to an embodiment of the present invention, the electrolyte for a dye sensitized solar cell may preferably further include guanidine thiocyanate. Guanidine thiocyanate is composed of a guadinine cation and a thiocyanate anion, and when added into an electrolyte, the guanidine thiocyanate may exist in a dissociated state, that is, as a cation and an anion. Since S-C-N of thiocyanate has the same structure as the S-C-N ligand of dye, the addition of guanidine thiocyanate may lead to the prevention of iodine ion-derived deterioration of dye in the electrolyte. Accordingly, when guanidine thiocyanate is added to the electrolyte, Jsc deterioration may be improved. According to an embodiment of the present invention, the guanidine thiocyanate is added at a concentration of 0.2 M or lower to the electrolyte, preferably about 0.0 M to 0.2M, preferably 0.05 M to 0.15 M.

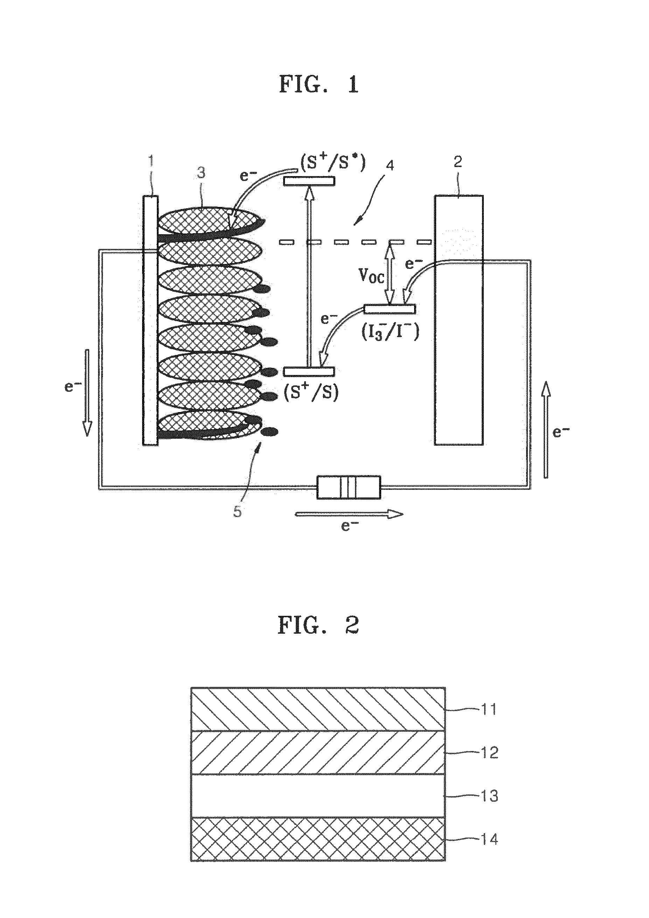

FIG. 1 is a diagram illustrating an operational principle of a comparable dye sensitized solar cell. Referring to FIG. 1, when a dye molecule 5 absorbs solar light, an electron of the dye molecule 5 is transited from a ground state to an excited state to form an electron-hole pair, and the excited electron is injected into a conduction band at an interface of particles of a porous film 3, and the injected electron is transferred to a first electrode 1 through an interface between the porous film 3 and the first electrode 1, and is flown to a second electrode 2 through an external circuit. Also, dye that is oxidized due to the transition of electrons is reduced by an iodine ion (I⁻) of a redox couple in an electrolytic solution 4, and an oxidized tri-valent iodine ion (I₃⁻) may take part in a reduction reaction with electrons that arrive at the surface of the second electrode 2 to obtain charge neutrality. As described above, a dye sensitized solar cell, unlike a comparable p-n junction silicon-based solar cell, has an electrochemical principle that operates based on an interface reaction.

According to another embodiment of the present invention, a dye sensitized solar cell includes a first electrode, a light absorption layer formed on a side of the first electrode, a second electrode that is disposed to face the side of the first electrode with the light absorption layer thereon, and an electrolyte disposed between the first electrode and the second electrode.

An example of the dye sensitized solar cell is schematically illustrated in FIG. 2. The dye sensitized solar cell includes a first electrode 11, a light absorption layer 12, an electrolyte 13, and a second electrode 14, and the light absorption layer 12 may include a semiconductor fine particle and a dye molecule. Also, the first electrode 11 and the light absorption layer 12 may constitute a semiconductor electrode.

The electrolyte 13 is the same as the electrolyte described above.

The first electrode 11 may include a transparent substrate, and a conductive layer formed on the transparent substrate. A material for forming the transparent substrate may be any one of various transparent materials that enable external light to pass therethrough. Accordingly, the transparent substrate may be formed of glass or plastic materials. Examples of suitable plastic materials include polyethylene terephthalate (PET), polyethylenenaphthalate (PEN), polycarbonate (PC), polypropylene (PP), polyimide (PI), triacetyl cellulose (TAC), and a copolymer thereof.

Also, the transparent substrate may be doped with a material selected from the group consisting of Ti, In, Ga, and Al.

A conductive layer may be disposed on the transparent substrate.

The conductive layer may include a conductive metal oxide selected from the group consisting of indium tin oxide (ITO), fluorine tin oxide (FTO), ZnO-(Ga₂O₃ or Al₂O₃), a tin-based oxide, an antimony tin oxide (ATO), zinc oxide, and a mixture thereof. For example, SnO₂, which has conductivity, transparency, and heat resistance, may be used; indium tin oxide (ITO), which is relatively inexpensive, may be used alone; and a composite layer of indium tin oxide (ITO) and other metal oxides, which are used to reduce a resistance after heat treatment, may be used.

The conductive layer may be formed of a single film or a multi-layer film of the conductive metal oxide.

The light absorption layer 12 is formed on a side of the first electrode 11. The light absorption layer 12 includes a porous film including a semiconductor fine particle and a photo sensitive dye adsorbed to the surface of the porous film.

The porous film may have a very fine, uniform nanoporous structure, and may include semiconductor fine particles having a very fine and uniform average particle size.

For use as the semiconductor fine particles, a single semiconductor, such as silicon, a compound semiconductor, or a compound with a perovskite structure may be used. As a semiconductor, an n-type semiconductor in which electrons of a conduction band, acting as a carrier, provides an anode current when excited by irradiation of light may be used. The compound semiconductor may be an oxide of metal selected from the group consisting of Ti, Zr, Sr, Zn, In, Yr, La, V, Mo, W, Sn, Nb, Mg, Al, Y, Sc, Sm, Ga, In, and TiSr. For example, the compound semiconductor may be TiO₂, SnO₂, ZnO, WO₃, Nb₂O₅, TiSrO₃, or a mixture thereof, and in one embodiment, an anatase-form TiO₂. The semiconductor is not limited thereto, and such semiconductors may be used alone or in combination. The surface area of the fine particles of such semiconductors may be increased to make more dye adsorbed onto the surface thereof to absorb more light, and to do this, a size of semiconductor fine particles may be 20 nm or lower.

The porous film may be manufactured by using a comparable porous film manufacturing process. For example, the porous film may be manufactured by using a mechanical necking process that does not require heat treatment and enables a film density of the porous film to be controlled by an appropriate adjustment of process conditions. However, the method of manufacturing a porous film is not limited thereto.

Dye, which absorbs external light to generate excited electrons, may be adsorbed onto the surface of the porous film.

The dye may be any one of various dyes that are used in the solar cell field. For example, the dye may be a ruthenium complex. However, the dye is not limited as long as it has a charge separation function and a light sensitivity. The dye may also be, in addition to the ruthenium complex, for example, a xanthine-based pigment, such as rhodamine B, rose bengal, eosin, or erythrocin; a cyanine-based pigment, such as quinocyanine, or cryptocyanine; a basic dye, such as phenosafranine, Capri blue, thiocine, or methyleneblue; a phosphirine-based compound, such as chloropyl, zinc phosphirine, or magnesium phosphirine; other azo pigments; a complex compound, such as a phthalocyanine compound, or Ru trisbipyridyl; an anthraquinone-based pigment; or a polycyclic quinine-based pigment, and these pigments may be used alone or in combination of two or more of these. The ruthenium complex may be RuL₂(SCN)₂, RuL₂(H₂O)₂, RuL₃, RuL₂, or the like (wherein L indicates 2,2'-bipyridyl-4,4'-dicarboxylate).

Also, a thickness of the light absorption layer 12 may be 15 µm or lower, for example, in a range of 1 to 15 µm. When the thickness of the light absorption layer 12 is greater than 15 µm, a series resistance increases due to its structure, and the increase in the series resistance causes a decrease in conversion efficiency. Accordingly, in embodiments, when the thickness of the light absorption layer 12 is 15 µm or lower, the light absorption layer 12 has low series resistance while retaining its function, thereby preventing a decrease in conversion efficiency.

The second electrode (also called a counter electrode) 14 is disposed facing the side of the first electrode 11 with the light absorption layer 12 thereon.

The second electrode 14 may be formed of a conductive material, and an insulating material may also be used to form the second electrode 14 as long as a conductive layer is formed to face the semiconductor electrode. In this regard, an electrochemically stable material may be used to form the second electrode 14, and in particular, platinum, gold, or carbon may be used. Also, to improve catalytic effects to oxidation and reduction, a portion of the second electrode 14 facing the semiconductor electrode may have a microstructure with an increased surface area, and for example, platinum is used in the form of platinum black, and carbon is used in a porous state. The platinum black may be formed by anodizing platinum or treating platinum with a chloroplatinic acid, and a porous carbon may be formed by sintering carbon fine particles or calcining an organic polymer.

A method of manufacturing a solar cell having such a structure is known in the art, and accordingly, one of ordinary skill in the art may sufficiently understand the method. Thus, the detailed description of the method is omitted in the present specification.

Hereinafter, embodiments of the present invention are described in more detail. However, the embodiments are provided for illustrative purpose only, and do not limit the scope of the invention.

### PREPARATION OF ELECTROLYTE

### Preparation Example 1

1.2 M 1-butyl-3-methylimidazolium iodide, and 0.12 M I₂ were dissolved in a mixed solvent in which valeronitrile (VN), dimethylsulfoxide (DMSO), and dimethylacetamide (DMA) had been mixed at a volumetric ratio of 70:20:10.

0.1 M lithium perchlorate and 0.1 M 1-methylbenzimidazole were added as an additive to the resultant solution, which was then heated up to about 65°C and mixed for 30 minutes by magnetic stirring to prepare an electrolyte.

### Preparation Example 2

1.2 M 1-butyl-3-methylimidazolium iodide, 0.12 M I₂, and 0.1 M guanidine thiocyanate were dissolved in a mixed solvent in which valeronitrile (VN), dimethylsulfoxide (DMSO), and dimethylacetamide (DMA) had been mixed at a volumetric ratio of 70:20:10.

0.1 M lithium perchlorate and 0.1 M 1-methylbenzimidazole were added as an additive to the resultant solution, which was then heated up to about 65°C and mixed for 30 minutes by magnetic stirring to prepare an electrolyte.

### Preparation Example 3

An electrolyte was prepared with the same composition as in Preparation Example 2, except that 0.2 M lithium perchlorate and 0.2 M 1-methylbenzimidazole were added thereto as an additive.

### Preparation Example 4

An electrolyte was prepared with the same composition as in Preparation Example 2, except that 0.5 M lithium perchlorate and 0.5 M 1-methylbenzimidazole were added thereto as an additive.

### Comparative Preparation Example 1

An electrolyte was prepared by dissolving 1.2 M 1-butyl-3-methylimidazolium iodide, and 0.12 M I₂ in a mixed solvent in which valeronitrile (VN), dimethylsulfoxide (DMSO), and dimethylacetamide (DMA) had been mixed at a volumetric ratio of 70:20:10.

In this experiment, additives were not used.

### Comparative Preparation Example 2

An electrolyte was prepared by adding 0.1 M guanidine thiocyanate to the electrolyte of Comparative Preparation Example 1 as an additive and dissolving 0.1 M guanidine thiocyanate.

### Comparative Preparation Example 3

An electrolyte was prepared by adding 0.2 M 1-methylbenzimidazole to the electrolyte of Comparative Preparation Example 2 as an additive.

### Comparative Preparation Example 4

An electrolyte was prepared by adding 0.2 M MgI₂ and 0.2 M 1-methylbenzimidazole to the electrolyte of Comparative Preparation Example 2 as an additive.

### Comparative Preparation Example 5

An electrolyte was prepared by adding 0.2 M Csl and 0.2 M 1-methylbenzimidazole to the electrolyte of Comparative Preparation Example 2 as an additive.

### MANUFACTURING OF DYE SENSITIZED SOLAR CELL

### Example 1

TiO₂ paste (PST-18NR, JGC C&C, Japan) was coated on a fluorine-containing tin oxide (FTO) substrate (thickness: 2.3 mm) by screen printing to form a coating layer having a thickness of 12 µm, and then, the temperature was increased at a rate of 10 °C/min to 500°C, at which the coating layer was calcined for 30 minutes, and then, scattering particle paste (400c, JGC C&C, Japan) was printed and calcined in the same manner as described above to form a photocathode having a thickness of about 4 µm.

The photocathode was immersed in a dye solution (0.2 mM N719/EtOH) for 24 hours. A counter electrode was prepared by sputtering Pt on FTO for 20 minutes.

A hot melt film (Suryln, DuPont, 60 µm) was inserted into a space between the photocathode and the counter electrode having holes, and then, the resultant structure was subjected to thermal adhesion (130°C/ 15 sec) by using a hot press.

The electrolyte prepared according to Preparation Example 1 was provided through the holes of the counter electrode to complete manufacturing of a dye sensitized solar cell.

### Example 2

A dye sensitized solar cell was manufactured in the same manner as in Example 1, except that the electrolyte prepared according to Preparation Example 2 was used.

### Example 3

A dye sensitized solar cell was manufactured in the same manner as in Example 1, except that the electrolyte prepared according to Preparation Example 3 was used.

### Example 4

A dye sensitized solar cell was manufactured in the same manner as in Example 1, except that the electrolyte prepared according to Preparation Example 4 was used.

### Comparative Example 1

A dye sensitized solar cell was manufactured in the same manner as in Example 1, except that the electrolyte prepared according to Comparative Preparation Example 1 was used.

### Comparative Example 2

A dye sensitized solar cell was manufactured in the same manner as in Example 1, except that the electrolyte prepared according to Comparative Preparation Example 2 was used.

### Comparative Example 3

A dye sensitized solar cell was manufactured in the same manner as in Example 1, except that the electrolyte prepared according to Comparative Preparation Example 3 was used.

### Comparative Example 4

A dye sensitized solar cell was manufactured in the same manner as in Example 1, except that the electrolyte prepared according to Comparative Preparation Example 4 was used.

### Comparative Example 5

A dye sensitized solar cell was manufactured in the same manner as in Example 1, except that the electrolyte prepared according to Comparative Preparation Example 5 was used.

### Evaluation Example 1: short current density (Jsc) and power conversion efficiency (PCE) measurement of dye sensitized solar cell

A current-voltage curve of the dye sensitized solar cells manufactured according to Examples 1 to 4 and Comparative Examples 1 to 5 obtained under reference measurement conditions (AM1.5G, 100 mW cm⁻²) was evaluated.

Also, a short current density (Jsc) of the dye sensitized solar cells was measured by using Keithley SMU2400, and power conversion efficiency (PCE) was measured by using 1.5AM 100 mW/cm² of a solar simulator (Xe lamp, [300W, Oriel], AM1.5 filter, and Keithley SMU2400).

Here, a xenon lamp (Oriel, 01193) was used as a light source, and light irradiation conditions (spectral distribution: AM 1.5) of the xenon lamp were adjusted by using a reference solar cell (Frunhofer Institute Solare Engeriessysteme, Certificate No. C-ISE369, Type of material: Mono-Si + KG filter).

### (1) Short current density (Jsc) analysis with respect to time.

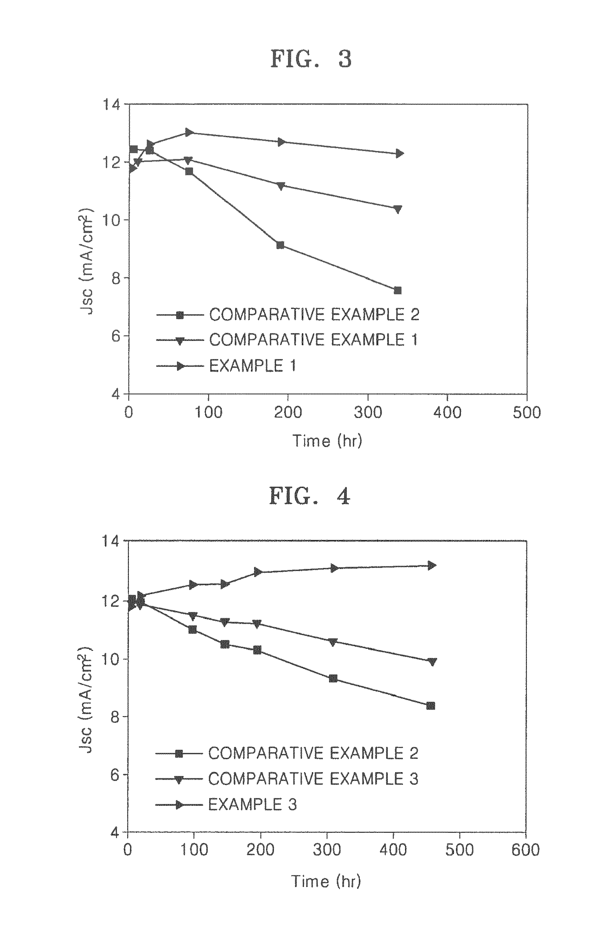

FIG. 3 shows short current density (Jsc) measurement results of the dye sensitized solar cells of Comparative Examples 1 and 2 and Example 1 over time.

Referring to FIG. 3, when guanidine thiocyanate was added to an electrolyte, the addition affected only initial characteristics of a dye sensitized solar cell (for example, the dye sensitized solar cell manufactured according to Comparative Example 2), and efficiency of the dye sensitized solar cell decreased rapidly over time. On the other hand, in the case of the dye sensitized solar cell of Example 1 in which LiClO₄ and 1-methylbenzimidazole were added together to the electrolyte, although guanidine thiocyanate was not added, deterioration of short current density (Jsc) over time of the dye sensitized solar cell was substantially improved compared to the dye sensitized solar cells of Comparative Examples 1 and 2, and accordingly, it was confirmed that lifespan characteristics had been improved.

Also, short current density (Jsc) of the dye sensitized solar cells of Comparative Examples 2 and 3 and Example 3 over time was measured and results thereof are shown in FIG. 4.

Referring to FIG. 4, the electrolyte of Example 3 in which LiClO₄ and 1-methylbenzimidazole were used together had better short current density characteristics than the electrolyte of Comparative Example 2 in which only guanidine thiocyanate was added and the electrolyte of Comparative Example 3 in which guanidine thiocyanate and 1-methylbenzimidazole were added, and accordingly, it was confirmed that the dye sensitized solar cell of Example 3 had better lifespan characteristics than the dye sensitized solar cells of Comparative Examples 2 and 3.

### (2) Short current density (Jsc) and power conversion efficiency (PCE) analysis.

Short current density (Jsc)-voltage (V) characteristics of a dye sensitized solar cell according to an additive and a concentration thereof were measured under the following conditions.

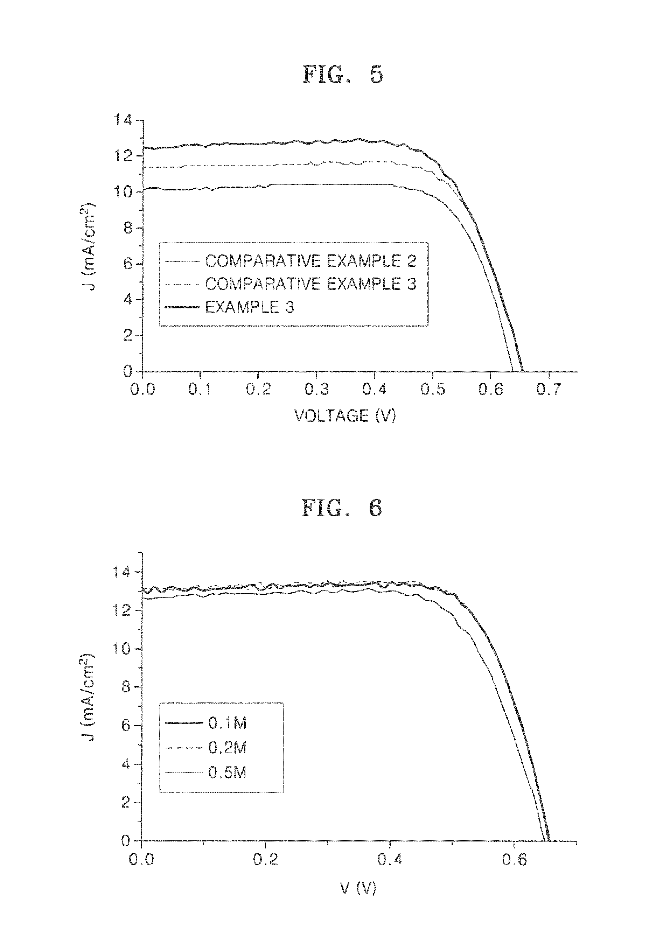

First, the dye sensitized solar cells of Comparative Examples 2 and 3 and Example 3 were subjected to thermal aging in a chamber at a temperature of 85°C for 144 hours, and then, under a condition of 1SUN irradiance (a reference light source condition of 100 mW/cm²), solar cell J-V characteristics were measured, and results thereof were illustrated in FIG. 5.

Referring to FIG. 5, when 1-methylbenzimidazole and lithium perchlorate were added together (in the case of Example 3), J-V characteristics were improved compared to when neither 1-methylbenzimidazole nor lithium perchlorate were added (in the case of Comparative Example 2) and when only one of 1-methylbenzimidazole and lithium perchlorate was added, for example, when only 1-methylbenzimidazole was added (in the case of Comparative Example 3).

Also, the dye sensitized solar cells of Examples 2, 3 and 4 (with a concentration of the additive at 0.1 M, 0.2 M and 0.3 M respectively) were subjected to thermal aging in a chamber at a temperature of 85°C for 5 hours, and then, under a condition of 1 SUN irradiance (a reference light source condition of 100 mW/cm²), solar cell J-V characteristics were measured, and results thereof were illustrated in FIG. 6.

As shown in FIG. 6, J-V characteristics were uniformly improved regardless of the concentration of the additive.

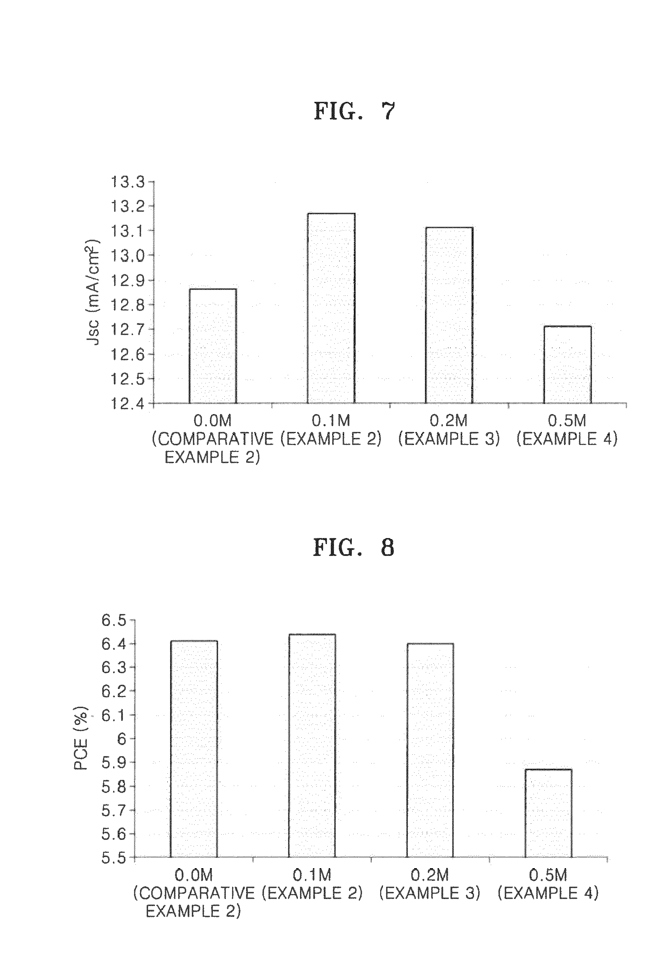

FIGS. 7 and 8 are graphs of short current density (Jsc) and power conversion efficiency (PCE) of the dye sensitized solar cells of Comparative Example 2 and Examples 2 through 4, respectively.

Referring to FIGS. 7 and 8, lithium perchlorate showed significant results at a concentration of less than 0.5 M, and also, it was considered that perchlorate would exhibit a maximum efficiency at a concentration of 0.1 M to 0.2 M. Lifespan characteristics were the most stable at a concentration of 0.2 M.

### (3) Power conversion efficiency (PCE) characteristics with respect to time according to an additive that is additionally used.

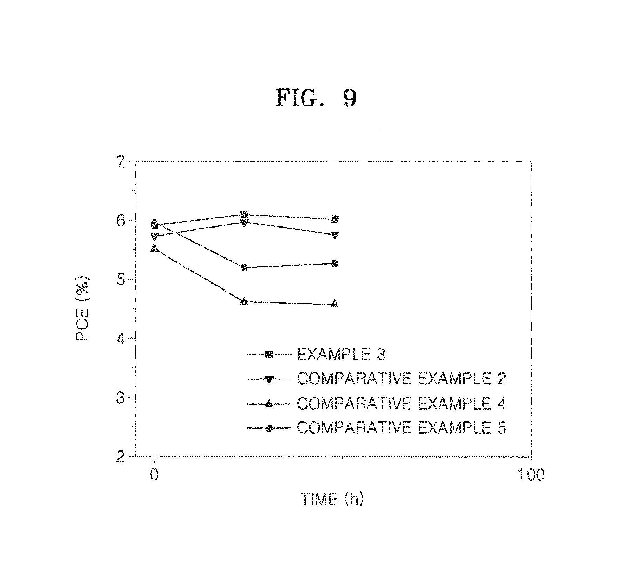

High-temperature (60°C) lifespan of the dye sensitized solar cells manufactured according to Comparative Examples 2, 4, and 5, and Example 3, were measured under a reference light source condition of 100 mW/cm², that is, power conversion efficiency characteristics with respect to time were obtained, and the results are shown in FIG. 9. In FIG. 9, PCE characteristics with respect to time were evaluated based on a ratio of η to η0 (η/η0) where η0 is an initial efficiency when the time is 0 and η is an efficiency at a corresponding time.

Referring to FIG. 9, the electrolyte of Example 3 showed higher efficiency stability than the electrolyte of Comparative Examples 2, 4, and 5. That is, when 1-methylbenzimidazole is used together with LiClO₄, lifespan characteristics of a dye sensitized solar cell were improved compared to when 1-methylbenzimidazole is used together with MgI₂ or CsI

### Evaluation Example 2: Interface resistance analysis of dye sensitized solar cell

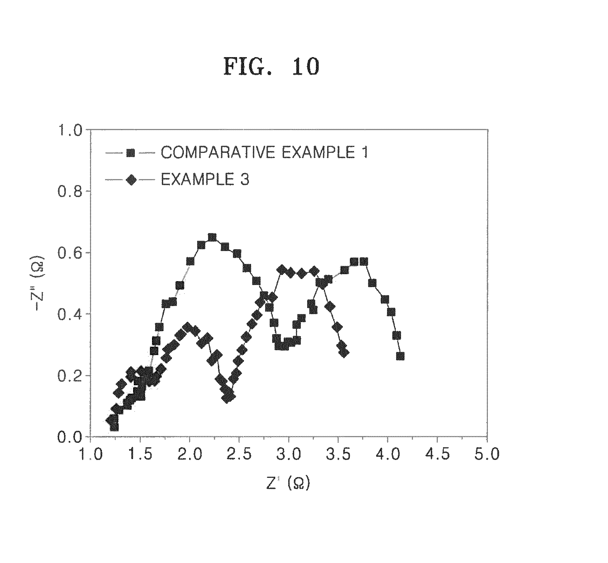

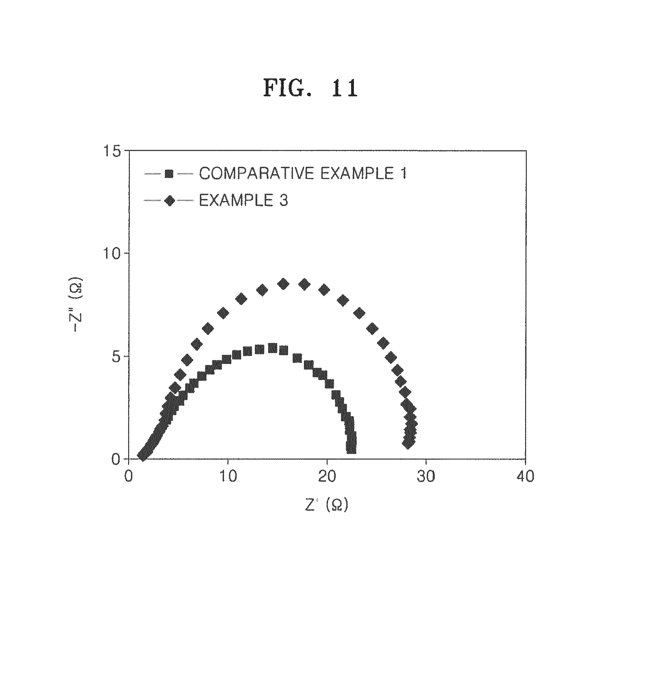

An interface resistance of the dye sensitized solar cells of Comparative Example 1 and Example 3 was measured in a frequency number region of 1 to 10⁶ Hz after exposure to 1 sun, AM 1.5 of light for 336 hours, and after being left in a dark condition for 336 hours, and respective results thereof are shown in FIGS. 10 and 11.

In FIG. 10, the curve of the interface resistance of each of the dye sensitized solar cells has sequential semicircles, and the total area refers to the total amount of resistance. First, for each, the smallest semicircle shows a resistance at an interface between platinum and an electrolyte, and the resistance does not largely affect efficiency of a dye sensitized solar cell. The second semicircle shows a resistance at interfaces of TiO₂, dye, and an electrolyte, and is generally used to analyze efficiency and deterioration at interfaces of a photoelectrode, dye, and electrolyte. The remaining semicircle shows a resistance associated with diffusion of oxidized I₃⁻ in an electrolyte, and is used to explain reproduction of electrons and a recombination phenomenon.

As illustrated in FIG. 10, regarding the resistance associated with the second semicircle of TiO₂/dye/electrolyte, it was confirmed that the dye sensitized solar cell of Example 3 had a smaller resistance than that of Comparative Example 1 because LiClO₄ and 1-methylbenzimidazole were added together to the electrolyte. This result refers to that the addition of LiClO₄ and 1-methylbenzimidazole contributed to an improvement of efficiency of a photoelectrode.

FIG. 11 shows results obtained in a dark condition in which light was not irradiated. Since in a dark condition, a dye sensitized solar cell is not driven, a series resistance needs to be high to prevent the flow of leakage current. As shown in FIG. 11, it was confirmed that the dye sensitized solar cell of Example 3 had a greater resistance than that of Comparative Example 1, in a dark condition.

### Evaluation Example 3: High-temperature stability analysis

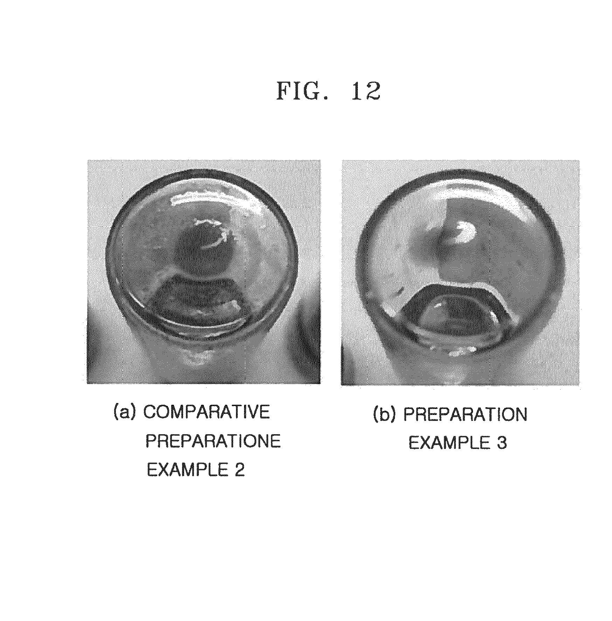

High-temperature stability of an electrolyte was analyzed as follows: the electrolytes of Comparative Preparation Example 2 and Preparation Example 3 were left at a temperature of 85°C for 100 hours and then whether precipitation occurred was identified. Results thereof are shown in FIG. 12.

Referring to FIG. 12, when the electrolyte of Comparative Preparation Example 2 was left at high temperature, precipitation occurred, whereas when the electrolyte of Preparation Example 3 to which LiClO₄ and 1-methylbenzimidazole were added was left at high temperature, precipitation did not occur. Accordingly, it was confirmed that the addition of LiClO₄ and 1-methylbenzimidazole to an electrolyte results in high-temperature stability.

An electrolyte for a dye sensitized solar cell according to an embodiment of the present invention includes as an additive lithium perchlorate and 1-methylbenzimidazole. Due to the inclusion of such additives, rapid Jsc deterioration, which occurs in a dye sensitized solar cell during use of a liquid electrolyte, decreases, and thus, lifespan characteristics improve.

While the present invention has been particularly shown and described with reference to some example embodiments thereof, it will be understood by those of ordinary skill in the art that various changes in form and details may be made therein without departing from the scope of the present invention as defined by the following claims, and equivalents thereof.

## Claims

1. An electrolyte for a dye sensitized solar cell, comprising:
lithium perchlorate; and
1-methylbenzimidazole.

2. The electrolyte of claim 1, wherein a concentration of the lithium perchlorate is more than 0 and less than 0.5 M, optionally about 0.1 to about 0.3 M.

3. The electrolyte of claim 1, wherein a concentration of the 1-methylbenzimidazole is more than 0 and less than 0.5 M, optionally about 0.1 to about 0.3 M.

4. The electrolyte of any of claims 1 to 3, wherein the electrolyte is a liquid electrolyte comprising an organic solvent.

5. The electrolyte of claim 4, wherein a boiling point of the organic solvent is equal to or higher than about 120°C.

6. The electrolyte of any of claims 1 to 5, wherein the electrolyte comprises, as a redox derivative, at least one salt selected from the group consisting of an imidazolium salt, a pyridinium salt, a quaternary ammonium salt, a pyrrolidinium salt, a thiazolinium salt, a pyridazinium salt, an isothiazolidinium salt, and an isooxyzolidinium salt.

7. The electrolyte of claim 6, wherein the redox derivative is the imidazolium salt.

8. The electrolyte of claim 7, wherein the imidazolium salt is at least one salt selected from the group consisting of 1-methyl-3-propylimidazolium iodide, 1,3-dimethylimidazolium iodide, 1-ethyl-3-methylimidazolium iodide, 1-butyl-3-methylimidazolium iodide, 1-methyl-3-pentylimidazolium iodide, 1-hexyl-3-methylimidazolium iodide, 1-heptyl-3-methylimidazolium iodide, 1-methyl-3-octylimidazolium iodide, 1,3-diethylimidazolium iodide, 1-ethyl-3-propylimidazolium iodide, 1-ethyl-3-butylimidazolium iodide, 1,3-dipropylimidazolium iodide, and 1-butyl-3-propylimidazolium iodide.

9. The electrolyte of any of claims 1 to 8, further comprising:
guanidine thiocyanate.

10. The electrolyte of claim 9, wherein a concentration of the guanidine thiocyanate included in the electrolyte is about 0.2 M or lower.

11. A dye sensitized solar cell comprising:
a first electrode;
a light absorption layer on a side of the first electrode;
a second electrode facing the side of the first electrode with the light absorption layer thereon; and
the electrolyte of any of claims 1 to 10 between the first electrode and the second electrode.
